Europäisches Patentamt

European Patent Office

Office européen des brevets

(11) Veröffentlichungsnummer: **0 473 083 A2**

# EUROPÄISCHE PATENTANMELDUNG

(21) Anmeldenummer: **91114217.2**

(22) Anmeldetag: **24.08.91**

(51) Int. Cl.5: **C11D 3/18**, C11D 1/22, C11D 1/825

(30) Priorität: **30.08.90 DE 4027445**

(43) Veröffentlichungstag der Anmeldung:
**04.03.92 Patentblatt 92/10**

(84) Benannte Vertragsstaaten:
**AT BE CH DE DK ES FR GB GR IT LI NL SE**

(71) Anmelder: **Kali-Chemie Aktiengesellschaft**
**Postfach 220, Hans-Böckler-Allee 20**
**W-3000 Hannover 1(DE)**

(72) Erfinder: **Buchwald, Hans**
**Am Rodelberg 51A**
**W-3003 Ronnenberg 3(DE)**
Erfinder: **Brackmann, Andreas**
**Hedwigstrasse 10**
**W-3000 Hannover 1(DE)**
Erfinder: **Raszkowski, Boleslaus**
**In der Hespe 246**
**W-3061 Wiedensahl(DE)**

(74) Vertreter: **Lauer, Dieter, Dr.**
**c/o Solvay Deutschland GmbH, Postfach 220**
**W-3000 Hannover(DE)**

(54) Reinigungszusammensetzungen mit wasserstoffhaltigen Fluorchlorkohlenwasserstoffen.

(57) Die Erfindung bezieht sich auf Zusammensetzungen, die sich durch einen Gehalt von ausgewählten wasserstoffhaltigen Fluorchlorkohlenwasserstoffen, ausgewählten grenzflächenaktiven Agentien, sowie gegebenenfalls Wasser und gegebenenfalls Ammoniak auszeichnen.

EP 0 473 083 A2

Die Erfindung bezieht sich auf Zusammensetzungen mit wasserstoffhaltigen Fluorchlorkohlenwasserstoffen, die ausgewählte grenzflächenaktive Agentien und gegebenenfalls Wasser enthalten.

Vollhalogenierte Fluorchlorkohlenwasserstoffe werden im Stand der Technik als Lösungsmittel in einer Vielzahl verschiedener Reinigungs- und Trocknungsanwendungen eingesetzt, da sie die hohen Anforderungen an die Löseeigenschaften im Hinblick auf die zu entfernenden Verunreinigungen, gegebenenfalls in Verbindung mit Co-Lösungsmitteln oder weiteren an sich für Reinigungs- und Trocknungsanwendungen üblichen Zusätzen, sehr gut erfüllen. Die vollhalogenierten Fluorchlorkohlenwasserstoffe sind jedoch mit dem großen Nachteil behaftet, daß sie in den oberen Luftschichten der Erdatmosphäre zur gefährlichen Verminderung des Ozongehalts dieser Luftschichten beitragen. Aufgrund dieser die Umwelt beeinträchtigenden Eigenschaften der vollhalogenierten Fluorchlorkohlenwasserstoffe ist ein Ersatz von Reinigungs- und Trocknungszusammensetzungen, die diese vollhalogenierten Fluorchlorkohlenwasserstoffe enthalten, durch alternative Reinigungs- und Trocknungszusammensetzungen mit in dieser Hinsicht weniger bedenklichen Lösungsmitteln wünschenswert. Diese Lösungsmittel, insbesondere wenn sie für die Reinigung oder Trocknung von elektronischen Bauteilen, gedruckten Leiterplatten, empfindlichen Geräteteilen, Präzisionsgeräten und Schutzschaltungen, wie z.B. Fehlerstromschutzschaltern eingesetzt werden sollen, müssen jedoch eine Reihe weiterer Forderungen erfüllen. So dürfen die Lösungsmittel die zu reinigenden bzw. zu trocknenden Gegenstände nicht beeinträchtigen, d.h. sie dürfen insbesondere weder auf Metallteile korrosiv wirken noch Kunststoffteile angreifen.

Es wurde nun gefunden, daß Reinigungszusammensetzungen mit einem Gehalt von 0,25 bis 35 Gew.-% eines grenzflächenaktiven Agens, welches ausgewählt ist aus Ammoniumsalzen von Alkylbenzolsulfonaten und/oder Gemischen von Fettsäurealkanolamiden und Alkylphenolpolyglykolethern, und wenigstens 65 Gew.-% eines oder mehrerer wasserstoffhaltiger Fluorchlorkohlenwasserstoffe, welche ausgewählt sind aus Trichlordifluorethan, Dichlortrifluorethan, Dichlormonofluorethan und Dichlorpentafluorpropan, sowie gegebenenfalls Wasser und gegebenenfalls Ammoniak, wobei die Summe der Bestandteile 100 Gew.-% ist, gut für industrielle Reinigungs- und Trocknungsverfahren geeignet sind. In einer bevorzugten Ausgestaltung der Erfindung zeichnen sich die erfindungsgemäßen Zusammensetzungen dadurch aus, daß sie, bezogen auf die Gesamtzusammensetzung, 0,5 bis 5 Gew.-% des grenzflächenaktiven Agens enthalten.

Trichlordifluorethane im Sinne der Erfindung sind die ein Wasserstoffatom tragenden Fluorchlorkohlenwasserstoffe der Summenformel $C_2HCl_3F_2$. Es handelt sich also um die drei nicht vollhalogenierten isomeren Fluorchlorkohlenwasserstoffe 1,1,1-Trichlor-2,2-difluorethan (R122b), 1,1,2-Trichlor-2,2-difluorethan (R122) und 1,1,2-Trichlor-1,2-difluorethan (R122a).

Dichlortrifluorethane im Sinne der Erfindung sind die ein Wasserstoffatom tragenden Fluorchlorkohlenwasserstoffe der Summenformel $C_2HCl_2F_3$. Es handelt sich also um die drei nicht vollhalogenierten isomeren Fluorchlorkohlenwasserstoffe 1,1-Dichlor-2,2,2-trifluorethan (R123), 1,2-Dichlor-1,1,2-trifluorethan (R123a) und 1,1-Dichlor-1,2,2-trifluorethan (R123b).

Dichlormonofluorethane im Sinne der Erfindung sind die drei Wasserstoffatome tragenden Fluorchlorkohlenwasserstoffe der Summenformel $C_2H_3Cl_2F$. Es handelt sich also um die drei nicht vollhalogenierten isomeren Fluorchlorkohlenwasserstoffe 1,2-Dichlor-1-fluorethan (R141), 1,1-Dichlor-2-fluorethan (R141a) und 1,1-Dichlor-1-fluorethan (R141b).

Dichlorpentafluorpropane im Sinne der Erfindung sind die ein Wasserstoffatom tragenden Fluorchlorkohlenwasserstoffe der Summenformel $C_3HCl_2F_5$. Es handelt sich insbesondere um die nicht vollhalogenierten isomeren Fluorchlorkohlenwasserstoffe 1,2-Dichlor-1,1,2,3,3-pentafluorpropan, 2,3-Dichlor-1,1,1,2,3-pentafluorpropan, 1,1-Dichlor-2,2,3,3,3-pentafluorpropan (= 3,3-Dichlor-1,1,1,2,2-pentafluorpropan), 1,3-Dichlor-1,1,2,2,3-pentafluorpropan, 1,1-Dichlor-1,2,2,3,3-pentafluorpropan, 1,2-Dichlor-1,1,3,3,3-pentafluorpropan, 1,1-Dichlor-1,2,3,3,3-pentafluorpropan. Bevorzugte Dichlorpentafluorpropane sind 1,1-Dichlor-2,2,3,3,3-pentafluorpropan (R225ca) und 1,3-Dichlor-1,1,2,2,3-pentafluorpropan (R225cb).

Die erfindungsgemäßen Zusammensetzungen können die genannten wasserstoffhaltigen Fluorchlorkohlenwasserstoffe auch im Gemisch miteinander und/oder als Isomerengemisch enthalten. Zweckmäßig enthalten die Zusammensetzungen insbesondere wasserstoffhaltige Fluorchlorkohlenwasserstoffe aus der Gruppe der Dichlortrifluorethane und Dichlormonofluorethane, oder deren Gemische. Besonders bevorzugt sind Zusammensetzungen, in denen das Dichlortrifluorethan das Isomere 1,1-Dichlor-2,2,2-trifluorethan (R123) und das Dichlormonofluorethan das Isomere 1,1-Dichlor-1-fluorethan (R141b) ist oder in denen Gemische derselben enthalten sind. Aber auch Zusammensetzungen mit anderen Isomeren insbesondere von Dichlortrifluorethan oder Dichlormonofluorethan, also 1,2-Dichlor-1,1,2-trifluorethan (R123a), 1,1-Dichlor-1,2,2-trifluorethan (R123b), 1,2-Dichlor-1-fluorethan (R141) und 1,1-Dichlor-2-fluorethan (R141a), sind sehr gut geeignet.

In einer Variante der Erfindung enthalten die Reinigungszusammensetzungen als oberflächenaktives Agens ein Gemisch aus Fettsäurealkanolamid und Alkylphenolpolyglykolethern. Geeignete Fettsäurealkano-

2

lamide sind z.B. N-alkylierte Fettsäureamide der allgemeinen Formel $R^1$-CO-N($R^2$)-$(CH_2)_n$-OH, die durch Umsetzung von Alkanolaminen mit Fettsäuren, Fettsäuremethylestern oder Fettsäureglyceriden erhältlich sind, wobei $R^1$ für einen gesättigten oder ungesättigten Fettsäurerest, $R^2$ für Wasserstoff in Monoalkanolamiden oder für $-(CH_2)_n$-OH in Fettsäuredialkanolamiden steht und n eine ganze Zahl von 1 bis 6, bevorzugt aber die Zahl 2, bedeutet. Bevorzugt sind insbesondere Fettsäuredialkanolamide, besonders Fettsäurediethanolamide, worin der Rest $R^1$ der Fettsäurerest der Laurinsäure, Myristinsäure, Palmitinsäure, Stearinsäure, der Ölsäure und ggf. auch ein Fettsäurerest der Kokosfettsäuren ist. Geeignete Alkylphenolpolyglykolether sind z.B. solche mit mittleren Alkylresten, d.h. mit den C8- bis C12-Alkylresten Octyl, Nonyl, Decyl, Undecyl oder Dodecyl, und mit 5 bis 8 Ethylenoxideinheiten. In einer bevorzugten Ausgestaltung dieser Variante der Erfindung ist in den Reinigungszusammensetzungen ein Gemisch aus Ölsäurediethanolamid und Nonylphenolpolyglykolethern mit 7 bis 8 Ethylenoxideinheiten enthalten. Besonders bevorzugt sind hierbei Reinigungszusammensetzungen, in denen das Ölsäurediethanolamid zu den Nonylphenolpolyglykolethern im Gewichtsverhältnis 5:1 vorliegt.

Alkylbenzolsulfonate sind z.B. solche mit mittleren Alkylresten, d.h. mit den C8- bis C12-Alkyresten Octyl, Nonyl, Decyl, Undecyl oder Dodecyl. Es können in den erfindungsgemäßen Reinigungszusammensetzungen Ammoniumsalze der Alkylbenzolsulfonate mit z.B. den folgenden Aminen mit 2 bis 6 C-Atomen enthalten sein: Diethylamin, n-Propylamin, Isopropylamin, Diisopropylamin, n-Butylamin, Isobutylamin, tert-Butylamin, Cyclohexylamin. In einer bevorzugten Ausgestaltung dieser Variante der Erfindung zeichnen sich die Reinigungszusammensetzungen dadurch aus, daß sie als Alkylbenzolsulfonat-Ammoniumsalz das Isopropylammoniumdodecylbenzolsulfonat enthalten.

Die vorstehend beschriebenen erfindungsgemäßen Zusammensetzungen sind sehr gut zur Entfernung von Fett- und Ölverunreinigungen sowie zur Trocknung von Oberflächen geeignet. Um auch die Entfernung wasserlöslicher Verunreinigungen besser zu unterstützen, ist es zweckmäßig, den erfindungsgemäßen Zusammensetzungen aus grenzflächenaktivem Agens und wasserstoffhaltigem Fluorchlorkohlenwasserstoff, einen hierfür geeigneten Zusatz einzuverleiben. In einer vorteilhaften Variante der Erfindung betrifft diese daher auch solche Zusammensetzungen der oben angegebenen Art, die zusätzlich zu den genannten grenzflächenaktiven Agentien und wasserstoffhaltigen Fluorchlorkohlenwasserstoffen als einen weiteren Bestandteil eine gewisse Menge an Wasser enthalten. Der Wasseranteil wird durch die erfindungsgemäßen Zusammensetzungen sehr gut toleriert, d.h. es werden stabile Wasser-in-Öl-Emulsionen gebildet, ohne daß die Vorteile der Zusammensetzungen, beispielsweise durch Trennung der Emulsion in zwei Phasen (Wasser- und Öl-Phase) oder eine Umkehrung in eine Öl-in-Wasser-Emulsion, beeinträchtigt werden. In dieser Hinsicht sehr vorteilhafte Reinigungszusammensetzungen der Erfindung in Form einer Wasser-in-Öl-Emulsion zeichnen sich durch einen Gehalt von 0,5 bis 5 Gew.-% des grenzflächenaktiven Agens, 80 bis 99 Gew.-% eines der Fluorchlorkohlenwasserstoffe Dichlortrifluorethan oder Dichlormonofluorethan und 0,5 bis 15 Gew.-% Wasser aus,wobei die Summe der Bestandteile 100 Gew.-% ist.

In einer bevorzugten Ausgestaltung dieser Variante der Erfindung liegen Reinigungszusammensetzungen in Form einer Wasser-in-Öl-Emulsion vor, die sich durch einen Gehalt von 2 bis 3 Gew.-% des grenzflächenaktiven Agens, 88 bis 96 Gew.-% eines der wasserstoffhaltigen Fluorchlorkohlenwasserstoffe Dichlortrifluorethan oder Dichlormonofluorethan und 2 bis 9 Gew.-% Wasser auszeichnen.

Für die erfindungsgemäßen Zusammensetzungen, die in Form einer Wasser-in-Öl-Emulsion vorliegen, werden als oberflächenaktive Agentien insbesondere die Ammoniumsalze der Alkybenzolsulfonate verwendet. Ein ganz besonders bevorzugtes Alkylbenzolsulfonat-Ammoniumsalz ist hierbei das Isopropylammoniumdodecylbenzolsulfonat.

In einer besonderen, vorteilhaften Ausgestaltung der erfindungsgemäßen Reinigungszusammensetzungen, die in Form einer Wasser-in-Öl-Emulsion vorliegen, zeichnen sich diese durch einen zusätzlichen Gehalt vom 0,01 bis 2 Gew.-% Ammoniak, auf Kosten des Gewichtsmengenanteils des wasserstoffhaltigen Fluorchlorkohlenwasserstoffes, aus; der Gehalt der wasserstoffhaltigen Fluorchlorkohlenwasserstoffe beträgt in solchen Zusammensetzungen demnach 78 bis 98,99 Gew.-%, vorzugsweise 86 bis 95,99 Gew.-%, während die anderen Bestandteile wie grenzflächenaktives Agens und Wasser, in denjenigen Mengen enthalten sind, wie sie oben für Zusammensetzungen in Form von Wasser-in-Öl-Emulsionen angegeben sind.

Die erfindungsgemäßen Zusammensetzungen sind je nach Wassergehalt bei Raumtemperatur klare Lösungen oder Emulsionen, denen an sich bekannte Additive zugesetzt werden können. Eine Gruppe an sich bekannter Additive sind Stabilisatoren. Unter dieser Gruppe werden solche Verbindungen zusammengefaßt, die eine unerwünschte Reaktion von Bestandteilen der Zusammensetzung untereinander oder mit anderen Reaktionspartnern, wie beispielsweise Luftsauerstoff, Metall, Wasser usw., verhindern. Bekannte Stabilisatoren sind beispielsweise Nitroalkane, insbesondere Nitromethan, Nitroethan, Alkylenoxide, insbesondere Butylenoxid oder verzweigte Alkinole, wie z.B. 2-Methylbutin-(3)-ol-(2). Diese Stabilisatoren können allein oder miteinander in Kombination eingesetzt sein, wobei Mengen von 0,01 bis 5 Gew.-%, vorzugsweise von 0,05 bis 1 Gew.-%, bezogen auf das Gesamtgemisch gut geeignet sind. Eine weitere Gruppe von Additiven umfaßt an sich bekannte Verbindungen aus der Gruppe der Korrosionsinhibitoren, nichtionische oder ionische Emulgatoren, Farbstoffe etc.

Die erfindungsgemäßen Zusammensetzungen haben zahlreiche Anwendungsmöglichkeiten auf dem Sektor der Reinigung und/oder Trocknung. Bei diesen an sich bekannten Verfahren wird der zu reinigende Gegenstand in einer oder mehreren Stufen in flüssiges, gegebenenfalls erwärmtes Reinigungsgemisch getaucht oder mit dem Reinigungsgemisch besprüht. Die Reinigungswirkung kann bei weniger empfindlichen, zu reinigenden Gegenständen auch durch geeignete Maßnahmen, wie z.B. Ultraschall und/oder Rühren, sowie durch mechanische Einwirkung, wie z.B. Bürsten, gesteigert werden.

Die erfindungsgemäßen Zusammensetzungen eignen sich zum Reinigen und/oder Trocknen von Elastomeren, Metall-, Kunststoff- und Glasteilen bzw. -flächen sowie zur Textilreinigung (Chemischreinigung). Insbesondere eignen sich die erfindungsgemäßen Reinigungszusammensetzungen auch zur Reinigung von elektronischen Bauteilen, gedruckten Leiterplatten, empfindlichen Geräteteilen, Präzisionsgeräten und Schutzschaltungen, wie z.B. Fehlerstromschutzschaltern. Die hohen Anforderungen an die Reinigung dieser Gegenstände werden durch die erfindungsgemäßen Reinigungszusammensetzungen gut erfüllt.

Die erfindungsgemäßen Reinigungszusammensetzungen können beispielsweise auch zur Reinigung von Kleinteilen bzw. Schüttgut, sowie zur Entfernung von Fett- bzw. Fingerabdrücken von elektronischen Bauteilen, z.B. von Silicium-Wafern, eingesetzt werden. Ammoniakhaltige Zusammensetzungen sind hierbei auch gut zur Entfernung von oxidierten Oberflächenschichten von Metallteilen, beispielsweise von Kupferpräzisionsteilen, geeignet.

Die nachfolgenden Beispiele sollen die Erfindung weiter erläutern, ohne sie jedoch in ihrem Umfang zu begrenzen. Sofern nicht anders angegeben, sind % immer Gew.-%. Die in den Beispielen verwendeten Abkürzungen bedeuten:

| | |
|---|---|
| R122 | = 1,1,2-Trichlor-2,2-difluorethan |
| R123 | = 1,1-Dichlor-2,2,2-trifluorethan |
| R141b | = 1,1-Dichlor-1-fluorethan |
| R225 | = Dichlorpentafluorpropan (Isomerengemisch aus R225ca und R225cb im Gewichtsverhältnis 20:80) |
| R225ca | = 1,1-Dichlor-2,2,3,3,3-pentafluorpropan |
| R225cb | = 1,3-Dichlor-1,1,2,2,3-pentafluorpropan |
| IDS | = Isopropylammoniumdodecylbenzolsulfonat |
| ODA/NPE | = Ölsäurediethanolamid/Nonylphenolpolyglykol ether (5:1) |

Beispiel 1: Reinigung von Glaslinsen, Aluminiumplatten und Siliciumscheiben

In einer handelsüblichen 4-Kammer-Reinigungsanlage wurden Reinigungsversuche mit Glaslinsen, Aluminiumplatten und Siliciumscheiben durchgeführt, die mit Fingerabdrücken, Öl und/oder Fett verunreinigt waren. Die Reinigungszusammensetzungen, Reinigungsbedingungen und Reinigungsergebnisse sind in Tabelle 1 wiedergegeben.

In den in der Spalte "Ergebnis" mit "+ +" gekennzeichneten Fällen ist eine sehr gute Reinigungswirkung erzielt worden. Die gereinigten Glaslinsen, Aluminiumplatten und Siliciumscheiben waren bei Reinigung mit den erfindungsgemäßen Emulsionen Nr. 1.1 bis 1.3, im Gegensatz zur Reinigung in den Vergleichsversuchen V1 und V2 (nur reines Lösungsmittel ohne grenzflächenaktives Agens), einwandfrei sauber und völlig frei von Öl und Fett, sowie Fingerabdrücken.

Beispiel 2: Reinigung von Kupfer-Präzisionsteilen

In einer handelsüblichen 4-Kammer-Reinigungsanlage wurden analog Beispiel 1 Präzisionsteile aus Kupfer gereinigt, die eine oxidierte Oberflächenschicht aufwiesen. Zur Reinigung wurden Emulsionen mit Zusatz von Ammoniak verwendet. Die Reinigungszusammensetzungen, Reinigungsbedingungen und Reinigungsergebnisse sind in Tabelle 2 wiedergegeben.

Es wurde eine sehr gute Reinigungswirkung ("+ +") erzielt, wobei die oxidierte Oberflächenschicht vollständig entfernt war und die gereinigte Metalloberfläche einen besonders guten Metallglanz aufwies.

Beispiel 3: Reinigung von Schüttgut und Zählwerken

4

In einer handelsüblichen 3-Kammer-Reinigungsanlage wurden Reinigungsversuche mit Schüttgut (Transistorenkappen) zur Entfernung von Ziehölen und mit Zählwerken zur Entfernung von verharzten Ölen durchgeführt. Die Reinigungszusammensetzungen, Reinigungsbedingungen und Reinigungsergebnisse sind in Tabelle 3 wiedergegeben.

In den in der Spalte "Ergebnis" mit " + + " gekennzeichneten Fällen ist eine sehr gute Reinigungswirkung erzielt worden. Der zu reinigende Gegenstand bzw. das zu reinigende Schüttgut war jeweils nach der Behandlung einwandfrei sauber.

Beispiel 4: Trocknung von Siliciumscheiben

In einer handelsüblichen 4-Kammer-Trocknungsanlage wurden Trocknungsversuche an wassernassen Siliciumscheiben durchgeführt. Die Trocknungszusammensetzungen, Trocknungsbedingungen und Trocknungsergebnisse sind in Tabelle 4 wiedergegeben.

Es wurde eine sehr gute Trocknungswirkung ("+ +") erzielt. Die zu trocknenden Siliciumscheiben waren nach der Behandlung einwandfrei trocken.

Tabelle 1: Reinigungsergebnisse zu Beispiel 1

| Nr. | Zusammensetzungen für Bad 1 | Reinigungsbedingungen | Material | Ergebnis |
|---|---|---|---|---|
| 1.1 | R123-Emulsion:<br>5,0 % IDS<br>15,0 % Wasser<br>80,0 % R123 | 4-Bad:<br>1) 3 Min. Ultraschall (Emulsion)<br>2) 1 Min. siedend getaucht (R123)<br>3) 1 Min. Ultraschall (R123)<br>4) 1 Min. Dampfentfettung (R123) | a) Glaslinsen<br>b) Aluminium-<br>platten<br>c) Silicium-<br>scheiben | ++<br><br>++<br><br>++ |
| 1.2 | R141b-Emulsion:<br>2,0 % IDS<br>4,0 % Wasser<br>94,0 % R141b | 4-Bad:<br>1) 3 Min. Ultraschall (Emulsion)<br>2) 1 Min. siedend getaucht (R141b)<br>3) 1 Min. Ultraschall (R141b)<br>4) 1 Min. Dampfentfettung (R141b) | a) Glaslinsen<br>b) Aluminium-<br>platten<br>c) Silicium-<br>scheiben | ++<br><br>++<br><br>++ |
| 1.3 | R123/R141b-<br>Emulsion:<br>3,0 % IDS<br>8,0 % Wasser<br>44,5 % R123<br>44,5 % R141b | 4-Bad:             (* R123 oder R141b)<br><br>1) 3 Min. Ultraschall (Emulsion)<br>2) 1 Min. siedend getaucht (*)<br>3) 1 Min. Ultraschall (*)<br>4) 1 Min. Dampfentfettung (*) | a) Glas-<br>linsen<br>b) Aluminium-<br>platten<br>c) Silicium-<br>scheiben | ++<br><br>++<br><br>++ |
| V1 | R123 | 4-Bad:<br>1) 3 Min. Ultraschall (R123)<br>2) 1 Min. siedend getaucht (R123)<br>3) 1 Min. Ultraschall (R123)<br>4) 1 Min. Dampfentfettung (R123) | a) Glaslinsen<br>b) Aluminium-<br>platten<br>c) Silicium-<br>scheiben | schlecht<br><br>schlecht<br><br>schlecht |
| V2 | R123 | 4-Bad:<br>1) 3 Min. Ultraschall (R141b)<br>2) 1 Min. siedend getaucht (R141b)<br>3) 1 Min. Ultraschall (R141b)<br>4) 1 Min. Dampfentfettung (R141b) | a) Glaslinsen<br>b) Aluminium-<br>platten<br>c) Silicium-<br>scheiben | schlecht<br><br>schlecht<br><br>schlecht |

EP 0 473 083 A2

EP 0 473 083 A2

Tabelle 2: Reinigungsergebnis zu Beispiel 2

| Nr. | Zusammen-setzung für Bad 1 | Reinigungsbedingungen | Material | Ergebnis |
|---|---|---|---|---|
| 2.1 | R123-Emulsion:<br>2,5 % IDS<br>6,0 % Wasser<br>0,2 % Ammoniak<br>91,3 % R123 | 4-Bad:<br><br>1) 3 Min. Ultraschall (Emulsion)<br>2) 1 Min. siedend getaucht (R123)<br>3) 1 Min. Ultraschall (R123)<br>4) 1 Min. Dampfentfettung (R123) | Präzisions-teile aus Kupfer, oberflächen-oxidiert | ++ |

Tabelle 3: Reinigungsergebnisse zu Beispiel 3

| Nr. | Zusammen-setzungen für Bad 1 | Reinigungsbedingungen | Material | Ergebnis |
|---|---|---|---|---|
| 3.1 | 65,0 % R123 35,0 % ODA/NPE | 3-Bad: 1) 3 Min. Ultraschall 2) 1 Min. Ultraschall (R123) 3) 1 Min. Dampfentfettung (R123) | Elektro-zähler | ++ |
| 3.2 | 95,0 % R141b 5,0 % ODA/NPE | 3-Bad: 1) 3 Min. Ultraschall 2) 1 Min. Ultraschall (R141b) 3) 1 Min. Dampfentfettung (R141b) | Transistoren-kappen (Schüttgut) | ++ |
| 3.3 | 65,0 % R225 35,0 % ODA/NPE | 3-Bad: 1) 3 Min. Ultraschall 2) 1 Min. Ultraschall (R225) 3) 1 Min. Dampfentfettung (R225) | Elektro-zähler | ++ |
| 3.4 | 95,0 % R122 5,0 % ODA/NPE | 3-Bad: 1) 3 Min. Ultraschall 2) 1 Min. Ultraschall (R122) 3) 1 Min. Dampfentfettung (R122) | Transistoren-kappen (Schüttgut) | ++ |

EP 0 473 083 A2

Tabelle 4: Trocknungsergebnis zu Beispiel 4

| Nr. | Zusammensetzung für Bad 1 | Trocknungsbedingungen | Material | Ergebnis |
|---|---|---|---|---|
| 4.1 | 97,0 % R141b<br>3,0 % IDS | 4-Bad:<br>1) 1 Min. siedend getaucht<br>2) 1 Min. siedend getaucht (R141b)<br>3) 1 Min. siedend getaucht (R141b)<br>4) 1 Min. Dampfraum (R141b) | Silicium-scheiben | ++ |

**Patentansprüche**

1. Reinigungszusammensetzungen, gekennzeichnet durch einen Gehalt von 0,25 bis 35 Gew.-% grenzflächenaktivem Agens, welches ausgewählt ist aus Ammoniumsalzen von Alkylbenzolsulfonaten und/oder

9

Gemischen von Fettsäurealkanolamiden und Alkylphenolpolyglykolethern, und wenigstens 65 Gew.-% eines oder mehrerer wasserstoffhaltiger Fluorchlorkohlenwasserstoffe, welche ausgewählt sind aus Trichlordifluorethan, Dichlortrifluorethan, Dichlormonofluorethan und Dichlorpentafluorpropan, sowie gegebenenfalls Wasser und gegebenenfalls Ammoniak, wobei die Summe der Bestandteile 100 Gew.-% ist.

2. Reinigungszusammensetzungen nach Anspruch 1, gekennzeichnet durch einen auf die Gesamtzusammensetzung bezogenen Gehalt von 0,5 bis 5 Gew.-% des grenzflächenaktiven Agens.

3. Reinigungszusammensetzungen nach Anspruch 1, dadurch gekennzeichnet, daß sie als wasserstoffhaltigen Fluorchlorkohlenwasserstoff Dichlortrifluorethan und/oder Dichlormonofluorethan enthalten.

4. Reinigungszusammensetzungen nach Anspruch 1, dadurch gekennzeichnet, daß sie als Fettsäurealkanolamid/ Alkylphenolpolyglykolether-Gemisch, ein Gemisch aus Ölsäurediethanolamid und Nonylphenolpolyglykolether mit 7 bis 8 Ethylenoxideinheiten enthalten.

5. Reinigungszusammensetzungen nach Anspruch 4, dadurch gekennzeichnet, daß das Ölsäurediethanolamid zum Nonylphenolpolyglykolether im Gewichtsverhältnis 5:1 vorliegt.

6. Reinigungszusammensetzungen nach Anspruch 1, dadurch gekennzeichnet, daß sie als Alkylbenzolsulfonat-Ammoniumsalz das Isopropylammoniumdodecylbenzolsulfonat enthalten.

7. Reinigungszusammensetzungen nach Anspruch 1, in Form einer Wasser-in-Öl-Emulsion, gekennzeichnet durch einen Gehalt von 0,5 bis 5 Gew.-% des grenzflächenaktiven Agens, 80 bis 99 Gew.-% der wasserstoffhaltigen Fluorchlorkohlenwasserstoffe Dichlortrifluorethan oder Dichlormonofluorethan und 0,5 bis 15 Gew.-% Wasser, wobei die Summe der Bestandteile 100 Gew.-% ist.

8. Reinigungszusammensetzungen nach Anspruch 7, dadurch gekennzeichnet, daß sie 2 bis 3 Gew.-% des grenzflächenaktiven Agens, 88 bis 96 Gew.-% des Dichlortrifluorethans oder Dichlormonofluorethans und 2 bis 9 Gew.-% Wasser enthalten.

9. Reinigungszusammensetzungen nach Anspruch 7 oder 8, dadurch gekennzeichnet, daß sie als grenzflächenaktives Agens Isopropylammoniumdodecylbenzolsulfonat enthalten.

10. Reinigungszusammensetzungen nach einem der Ansprüche 7 bis 9, dadurch gekennzeichnet, daß sie einen zusätzlichen Gehalt von 0,01 bis 2 Gew.-% Ammoniak, auf Kosten des Gewichtsmengenanteils des wasserstoffhaltigen Fluorchlorkohlenwasserstoffes, enthalten.

11. Reinigungszusammensetzungen gemäß einem der vorhergehenden Ansprüche, gekennzeichnet durch einen zusätzlichen Gehalt an Stabilisator von 0,01 bis 5 Gew.-%, vorzugsweise 0,05 bis 1 Gew.-%, bezogen auf das Gesamtgemisch, vorzugsweise aus der Gruppe Nitroalkan, Alkylenoxid und/oder Alkinol.

12. Verwendung der Reinigungszusammensetzungen gemäß einem der vorhergehenden Ansprüche in Tauch-, Ultraschall- und/oder Sprühreinigungsverfahren.

13. Verwendung der Reinigungszusammensetzungen gemäß einem der Ansprüche 1 bis 11 zur Textilreinigung.

14. Verwendung der Reinigungszusammensetzungen gemäß einem der Ansprüche 1 bis 11 zur Entfernung von Wasser von Oberflächen.